# FASCICULE DE BREVET EUROPEEN

(11) **EP 3 140 867 B1**
(45) Date de publication et mention de la délivrance du brevet: **01.12.2021**
(21) Numéro de dépôt: 15718484.7
(22) Date de dépôt: 24.04.2015
(51) Int. Cl.: H01L 27/30

(54) **DISPOSITIF MATRICIEL DE DETECTION INCORPORANT UN MAILLAGE METALLIQUE DANS UNE COUCHE DE DETECTION ET PROCEDE DE FABRICATION**
MATRIXDETEKTOR MIT EINEM METALLGITTER IN EINER DETEKTIONSSCHICHT UND HERSTELLUNGSVERFAHREN
MATRIX DETECTION DEVICE INCORPORATING A METAL MESH IN A DETECTION LAYER, AND MANUFACTURING METHOD

(30) Priorité: 07.05.2014 FR 1454109
(43) Date de publication de la demande: 15.03.2017
(73) Titulaire: Commissariat à l'Énergie Atomique et aux Énergies Alternatives, 75015 Paris (FR)
(72) Inventeur: TALLAL, Jamal, F-76410 Saint Aubin Les Elbeuf (FR); CHARLOT, Simon, F-38100 Grenoble (FR); DAAMI, Anis, F-38000 Grenoble (FR); VERILHAC, Jean-Marie, F-38500 Coublevie (FR)
(74) Mandataire: Marks & Clerk France
(86) Numéro de dépôt international: PCT/EP2015/058941
(87) Numéro de publication internationale: WO 2015/169623

(56) Documents cités:
- WO-A1-2007/017474
- WO-A1-2009/156419
- US-A- 4 449 044
- US-A1- 2013 048 861
- None

## Description

Le domaine de l'invention est celui des dispositifs matriciels de détection comportant une matrice active intégrant un ou plusieurs transistors de commandes couplés avec un capteur. Le transistor peut être de nature organique, inorganique ou hybride organique/inorganique, le capteur pouvant être de préférence un capteur de lumière type photodiode imprimé, un capteur de température, de pression...

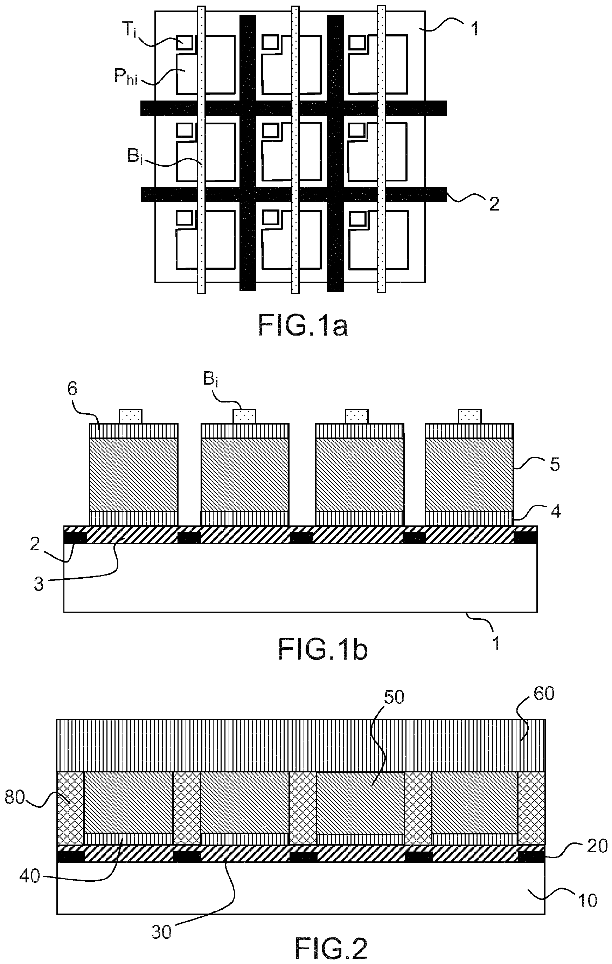

De manière connue, dans le domaine d'imageur commercial pour convertir les rayons X en image visible, le circuit d'acquisition optique et de lecture d'imageur est composé comme illustré en figures 1a et 1b, à la surface, d'un substrat 1, d'une matrice active de transistors Ti en couches minces (TFT- Thin Film Transistor) en silicium amorphe (a-Si) connectée avec des photodiodes Phi, en a-Si. Chaque transistor (ou groupe de transistors) Ti de type TFT commande un plot de pixel sur lequel est empilé un dispositif photodiode en a-Si. L'électrode du haut de chaque photodiode est constituée d'un plot en TCO (Transparent Conductive Oxyde - Oxyde transparent conducteur), chaque plot étant localisé spatialement et déconnecté de ses voisins. Afin de polariser électriquement tous les plots de TCO entre eux et à la même polarisation, des bus métalliques Bi très fins (quelques 10^{ème} de µm de largeur) connectent tous les plots entre eux, comme illustré en figure 1a. Sur un plot de diode, la surface des bus métalliques opaques est négligeable par rapport à la surface de la diode en TCO transparent. De plus, le design des lignes de bus métalliques, permet de minimiser les capacités parasites aux intersections entre les bus et les colonnes (comme décrit dans l'article: Thin Solid Films 337, 213-221 (1999)). La figure 1b, schématise une vue en coupe mettant en évidence les photodiodes Phi comprenant des électrodes discrètes 4, des éléments de couche photoconductrice 5, des électrodes supérieures 6 sur laquelle sont disposés les bus Bi. Les éléments 2 représentent des lignes/colonnes de commande de pixels de détection, isolés via une couche diélectrique 3, des électrodes discrètes 4.

La fabrication de ces matrices TFT et des photodiodes a-Si se fait à partir des techniques classiques de la microélectronique :
- l'utilisation de techniques de dépôts sous vide pour le dépôt des différentes couches formant l'empilement ;
- l'utilisation de techniques de photolithographie pour la localisation spatiale de ces couches de matériau afin de limiter au maximum les couplages électriques et les capacités parasites entre les pixels ainsi qu'entre les différents niveaux de contacts.

Une alternative prometteuse en termes de facilité de procédés et de coût consiste à faire une matrice active hybride organique/inorganique. Le principe est de démarrer d'une matrice active commerciale à base de TFT en a-Si par exemple et de remplacer la photodiode a-Si par une photodiode organique présentant un ou plusieurs niveaux imprimés par voie liquide (Applied Physics Letters 92, 213303 (2008)). L'électrode inférieure de la photodiode est constituée du plot de pixel en TCO connecté au transistor de commande, puis sont successivement déposées une couche de photoconversion organique composée d'un mélange de deux matériaux donneur/accepteur d'électrons, et enfin l'électrode supérieure.

Dans ce cas, les technologies de photolithographie classique ne s'appliquent pas facilement sur les couches organiques imprimées, notamment pour des raisons de compatibilité de solvants entre les couches. Il est ainsi plus avantageux de ne pas localiser spatialement ces couches et donc de les imprimer en pleine plaque. Malheureusement, ceci peut avoir comme conséquence de créer des effets parasites, tels que des fuites électriques inter-pixels ou des couplages capacitifs entre les lignes/colonnes de la matrice active et l'électrode supérieure, ce qui est préjudiciable au bon fonctionnement du dispositif. En effet, lorsque l'on souhaite lire l'information présente aux bornes d'un pixel d'une matrice active, le transistor devient passant pour permettre la lecture entre la borne inférieure de la diode et l'électrode supérieure pleine couche. Cette lecture peut être dégradée voire faussée par ces capacités parasites.

Au-delà des problèmes d'effets parasites, il y a également un paramètre important lors de la réalisation de matrice active : la résistivité de l'électrode supérieure de la photodiode. En effet, une forte résistivité va poser des problèmes lors de l'acquisition des images avec notamment un phénomène de latence (« LAG » en anglais) préjudiciable au bon fonctionnement des dispositifs. Les imageurs X classiques sont composés de matrices de photo-détection dans le visible, couplés à un scintillateur pour convertir les rayons X en lumière visible. Pour augmenter la résolution de détection, généralement caractérisée par la fonction de transfert de modulation ou Modulation Transfer Function (MTF), le scintillateur est placé du côté de la photodiode, ce qui nécessite que l'électrode supérieure de la photodiode soit transparente. De plus, dans de nombreux dispositifs, le contact sur l'électrode supérieure est repris en un ou plusieurs points localisés en périphérie de l'embase. Ceci est amplement suffisant dans le cas d'une électrode supérieure ayant une résistance carré faible (< 1 Ω/□).

Dans le cas de la photodiode en a-Si, une électrode supérieure en TCO est utilisée en combinaison avec des bus métalliques non transparents mais de surface négligeable par rapport à la surface de la diode. Cela permet d'allier à la fois l'impératif de transparence de l'électrode et la nécessité d'avoir une résistance carré très faible.

Dans le cas de la photodiode imprimée avec l'électrode supérieure plein champ, les contraintes sur l'électrode supérieure sont les mêmes. Malheureusement, dans le domaine des photo-détecteurs organiques, il est difficile de trouver des matériaux qui soient à la fois très bons conducteurs électriques, transparents, déposables par des techniques d'impression sur une couche organique et dont le solvant soit orthogonal à celui utilisé pour la couche photosensible. Un des produits qui allie le mieux ces différents prérequis est le PEDOT : PSS mais les résistances carré proposées par les fabricants restent à l'heure actuelle tout juste inférieures à 100 Ω/□ (Orgacon IJ-1005). Sur de faibles surfaces cette résistivité peut être acceptable mais lorsque l'on souhaite réaliser des matrices de pixel sur des surfaces supérieures à 50×50 mm², il devient primordial de diminuer cette résistance par carré.

Il est ainsi important de trouver des solutions pour diminuer la résistivité de l'électrode supérieure imprimée, et de diminuer les capacités parasites entre cette électrode supérieure et les lignes/colonnes de la matrice active.

Il est connu du Document US 4 449 044, un dispositif matriciel de détection comprenant un empilement comprenant une matrice de pixels d'éléments de détection, une matrice active comprenant un réseau de lignes et de colonnes de commande des pixels réalisés à la surface d'un substrat. Le dispositif comprend une électrode supérieure commune, une couche de détection, des électrodes inférieures discrètes, le dispositif comprenant un maillage relié à l'électrode supérieure et des plots incorporés dans ladite couche de détection.

Il est également connu du Document US 2013/048861, un dispositif de détection comprenant des plots opaques positionnés en correspondance avec un réseau de lignes et de colonnes.

Il est aussi connu du Document WO 2009/156419 et du Document WO 2007/017474 des capteurs d'image organiques.

Néanmoins, ces enseignements ne divulguent pas de solutions afin de diminuer la résistivité de l'électrode supérieure, et de diminuer les capacités parasites entre cette électrode supérieure et les lignes/colonnes de la matrice active.

Dans ce contexte, la solution de la présente invention permet de résoudre ces deux problèmes.

Plus précisément, la présente invention a pour objet un dispositif matriciel de détection de rayonnement selon la revendication 1.

De manière générale, dans la présente invention on définit une électrode discrète comme étant une par pixel, isolée de ses voisines et une électrode commune comme étant une électrode commune à au moins deux pixels.

Selon une variante de l'invention, la couche de détection est une couche commune de détection, soit une couche en contact direct d'un pixel à l'autre.

Selon une variante de l'invention, les pixels de détection sont des photodiodes.

Selon une variante de l'invention, le maillage métallique est séparé du réseau de lignes et de colonnes de commande, par une couche diélectrique de permittivité relative inférieure à environ 2,5.

Selon une variante de l'invention, lesdits plots comprennent une partie supérieure métallique et une partie inférieure en matériau diélectrique.

Selon une variante de l'invention, la partie inférieure desdits plots comporte une résine positive photosensible.

Selon une variante de l'invention, les pixels d'éléments de détection comprennent un ou des matériau(x) organique(s).

Selon une variante de l'invention, le matériau organique est un mélange de polymères de type p et de type n.

Selon une variante de l'invention, le réseau de lignes et de colonnes de commande desdits pixels est relié à un réseau de transistors de commande.

L'invention a aussi pour objet un procédé de fabrication d'un dispositif matriciel de détection selon la revendication 10.

Il est à noter que la couche de détection peut être déposée sous forme d'une couche unique ou bien il est possible de la localiser pour chaque pixel, par exemple par sérigraphie.

Selon une variante de l'invention, le procédé comprend les étapes suivantes :
- la réalisation d'un empilement de couches par les dépôts :
   o d'une couche de résine photosensible positive dite inférieure encapsulant lesdites électrodes discrètes inférieures de pixels élémentaires ;
   o d'une couche de métal ;
   o d'une couche de résine photosensible positive dite supérieure à la surface de ladite couche de métal ;
- l'insolation dudit empilement et le développement de ladite résine dite supérieure de manière à laisser des plots constitués de ladite résine dite supérieure ;
- la gravure de ladite couche métallique de manière à former des plots comprenant une partie supérieure en résine, une partie métallique ;
- la gravure d'une couche supérieure formée de résine supérieure et de résine inférieure de manière à constituer des plots présentant une partie métallique et une partie inférieure en résine ;
- la réalisation d'une couche de détection située entre lesdits plots et laissant à nu la surface supérieure desdits plots ;
- le dépôt d'une couche d'électrode supérieure au dessus de ladite couche de détection, en contact avec lesdits plots formés, permettant de constituer un maillage métallique relié à ladite électrode supérieure, incorporé dans ladite couche de

détection, ledit maillage étant positionné en correspondance avec ledit réseau de lignes et de colonnes de commande.

Selon une variante de l'invention, l'insolation de ladite résine positive est réalisée en face arrière dudit substrat, opposée à la surface comprenant ledit réseau de lignes et de colonnes de commande, ladite couche de métal étant telle qu'elle laisse passer une partie du rayonnement d'insolation.

Selon une variante de l'invention, l'insolation est effectuée également en face avant opposée à ladite face arrière, en présence d'un masque présentant des ouvertures dites de masque, positionnées en regard desdites électrodes inférieures.

Selon une variante de l'invention, le procédé comprend en outre :
- le dépôt d'une résine négative postérieure à la réalisation desdits plots comprenant une partie supérieure métallique ;
- l'insolation de ladite résine de manière à définir des ouvertures secondaires dans ladite résine négative, à la surface desdits plots de métal ;
- la croissance de métal dans lesdites ouvertures secondaires de manière à augmenter la hauteur desdits plots de métal.

Selon une variante de l'invention, la croissance de métal est effectuée par voie électrolytique.

Selon une variante de l'invention, si la couche de détection recouvre lesdits plots, le procédé comprend en outre :
- la réalisation d'ouvertures dans ladite couche de détection en correspondance avec le réseau de lignes et de colonnes ;
- le dépôt d'une couche d'électrode supérieure au dessus de ladite couche photosensible en contact avec lesdits plots formés et dans lesdites ouvertures permettant de constituer un maillage métallique relié à ladite électrode supérieure, incorporé à la surface desdits éléments de détection, ledit maillage étant positionné en correspondance avec ledit réseau de lignes et de colonnes de commande.

Selon une variante de l'invention, le procédé comprend une étape de démouillage de la couche de détection sur les plots présentant au moins une partie métallique permettant un contact direct de l'électrode supérieure avec lesdits plots, sans étape préalable d'ouverture dans ladite couche de détection (ce type d'ouverture pouvant être réalisée par ablation laser).

Selon une variante de l'invention, l'étape de démouillage comprend le greffage d'une monocouche auto-assemblée (SAM - Self assembled monolayer) sur les plots présentant au moins au moins une partie métallique afin de faire démouiller la couche de détection à cet endroit et permettre un contact direct entre lesdits plots et ladite électrode supérieure sans étape d'ouverture dans ladite couche de détection.

La présente invention a ainsi pour objet un dispositif matriciel de détection permettant de résoudre deux problèmes régulièrement rencontrés lors de la fabrication de matrices de détection et notamment dans celles de photo-détecteurs organiques avec des couches non localisées :
- la présence de capacités parasites entre les lignes/colonnes de commande et l'électrode supérieure pleine couche de la photodiode ;
- la forte résistance par carré de l'électrode supérieure transparente imprimée des photo-détecteurs organiques.

Dans le cadre de la présente invention, la réduction de la résistivité de l'électrode supérieure est assurée par la formation d'un maillage métallique qui par sa méthode de réalisation (insolation d'une résine à travers les zones opaques de la matrice) est la copie conforme du design des zones opaques de la matrice active (lignes, colonnes, TFT). Ce maillage se retrouve donc en regard des lignes et des colonnes.

Le dispositif matriciel de détection de l'invention, comporte une couche de diélectrique entre les lignes/colonnes de commande et le maillage métallique. Avantageusement, une couche diélectrique de faible permittivité relative (maximum 2,5) permet de diminuer les capacités parasites entre les différents niveaux conducteurs.

L'invention sera mieux comprise et d'autres avantages apparaîtront à la lecture de la description qui va suivre donnée à titre non limitatif et grâce aux figures annexées parmi lesquelles :
- les figures 1a et 1b illustrent un exemple d'imageur selon l'art connu ;
- la figure 2 illustre un exemple de dispositif matriciel de détection selon l'invention ;
- les figures 3a à 3l illustrent les différentes étapes d'un premier exemple de procédé de réalisation d'un dispositif de l'invention ;
- les figures 4a à 4c illustrent les différentes étapes d'un second exemple de procédé de réalisation d'un dispositif de l'invention.

Un schéma de dispositif matriciel de détection de la présente invention est illustré grâce à la figure 2. Il comprend, de manière connue, à la surface d'un substrat 10, une matrice de transistors (non représentés) connectés à des lignes/colonnes 20 de commande des pixels de détection. Il est rappelé que les lignes/colonnes de commande permettent d'activer le transistor de chaque pixel et que chaque transistor permet de commander/lire un pixel de détection.

Les pixels de détection comprennent :
- des électrodes inférieures discrètes 40 ;
- une couche de détection 50 ;
- une électrode supérieure commune auxdits pixels 60.

Une couche de diélectrique 30 isole les lignes et les colonnes conductrices 20, des électrodes inférieures 40.

Selon la présente invention, il est prévu un maillage dit métallique comprenant des plots 80 au moins partiellement métalliques. Les plots 80 du maillage métallique sont positionnés en correspondance, c'est-à-dire en regard du réseau de lignes/colonnes de commande 20 et isolés de celui-ci, et séparent des éléments de la couche de détection 50, en étant en contact avec ladite couche 50. Cette configuration est particulièrement intéressante dans le cas de dispositifs matriciels comportant des éléments de photodétection, dispositifs pour lesquels, on cherche à optimiser et donc réduire les zones opaques aux rayonnements que l'on cherche à détecter.

### Exemple de procédé de fabrication d'un dispositif matriciel de photodétection selon l'invention :

Ce procédé détaille essentiellement la réalisation de la partie photo-détecteur. Les matrices de transistors, les lignes/colonnes de commande ainsi que les électrodes inférieures de la partie photo-détection sont déjà préfabriquées à la surface d'un substrat.

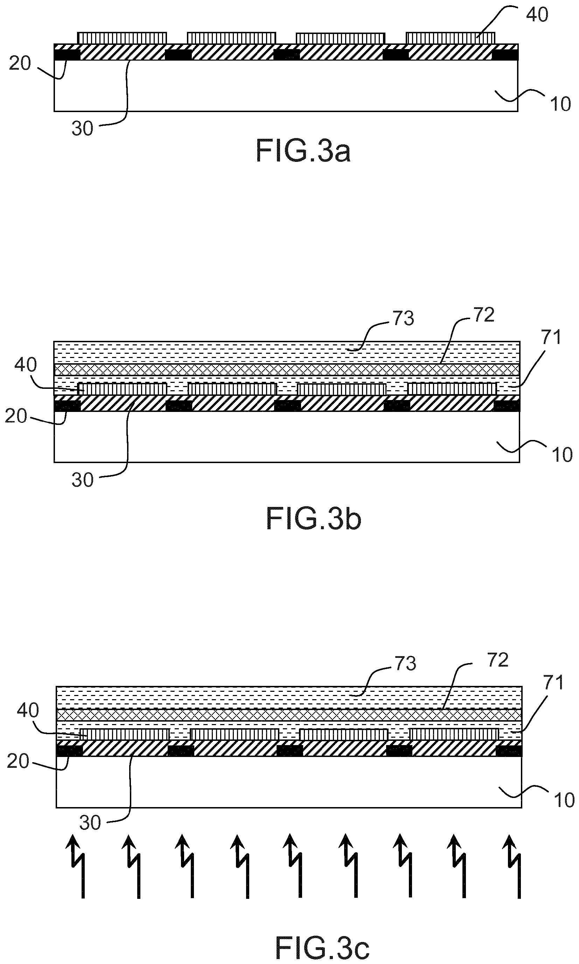

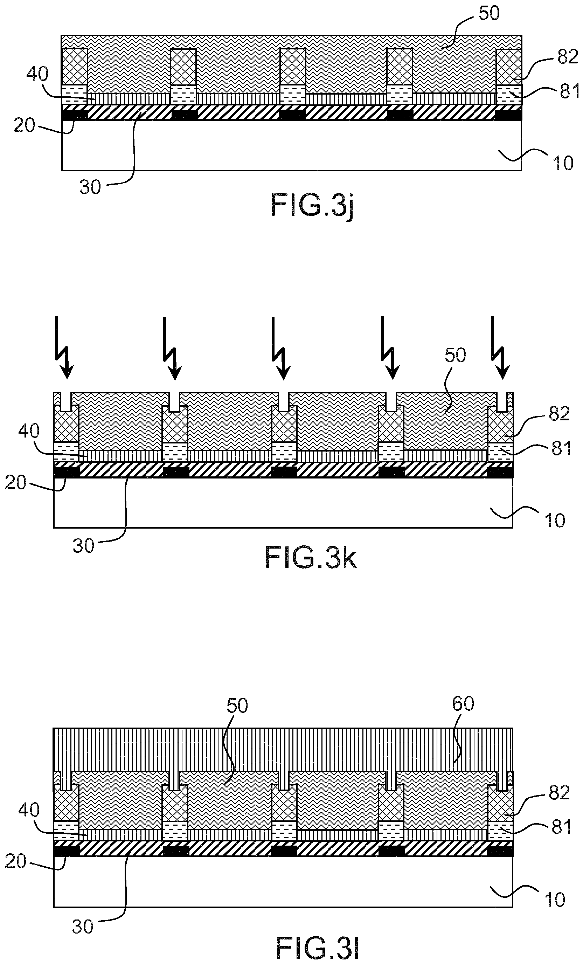

Les figures 3a à 3l représentent les différentes étapes du procédé de fabrication de l'invention.

### Première étape :

Comme représenté en figure 3a, on réalise sur un substrat 10, les lignes/colonnes de commande 20, l'isolation entre transistors et photo-détecteurs étant réalisée par une couche isolante diélectrique 30, les électrodes inférieures 40 des éléments de photodétection. Les lignes/colonnes sont généralement réalisées par dépôt sous vide d'une couche conductrice (aluminium, molybdène ...) suivi d'une étape de photolithographie et de gravure. La couche isolante est généralement du SiN (Nitrure de silicium) déposée par technique de dépôt sous vide. Enfin, les électrodes inférieures sont généralement des oxydes transparents conducteurs tel que l'ITO (Indium Tin Oxide - Oxide Indium Etain), déposés par dépôt PVD (Physical vapor déposition - Dépôt physique en phase vapeur), suivi d'une étape de photolithographie.

### Seconde étape :

Comme représenté en figure 3b, on procède aux dépôts successifs sur l'embase préconstituée :
- d'une résine positive photosensible 71, par exemple la S1818 de chez Shipley. Ce type de résine est généralement constituée de 3 matériaux : une matrice de type résine polymère (Novolak), un composé photoactif (composé de type diazo-, généralement diazonaphtoquinone) et d'un solvant type PGMEA (propylene glycol monomethyl ether acetate). L'épaisseur de cette couche peut varier de quelques nanomètres à plusieurs microns, idéalement autour de 1 à 2 µm. Le dépôt peut être effectué par spin-coating 2000 rpm (tours/minute) pendant 30 secondes pour une épaisseur finale de 1,2 µm) ou toute autre technique de dépôt de résine, suivi d'un recuit après dépôt de 115°C pendant 5 minutes sous N₂;
- d'une couche métallique 72 à faible résistivité, inférieure à 100 Ω/□, au mieux à 10 Ω/□, idéalement inférieure à 1 Ω/□, les résistances pouvant être facilement mesurées par la méthode 4 pointes ou TLM (Transmission Line Model). Il peut typiquement s'agir d'une couche en or. L'épaisseur de cette couche peut varier de quelques nanomètres à quelques microns en fonction de la résistance par carré souhaitée mais elle doit surtout être suffisamment transparente à la lumière UV/Visible pour laisser passer au moins 10% du flux lumineux incident, au mieux 50%, idéalement 98%. Cette couche est obtenue, par exemple, par évaporation sous vide à 2×10⁻⁶mBar d'une couche de 10nm d'or à la vitesse de 2Å/s ;
- d'une seconde résine positive photosensible 73, par exemple la S1818 de chez Shipley. L'épaisseur de cette couche peut varier de quelques nanomètres à plusieurs microns, idéalement autour de 1 à 2 µm. Le dépôt peut être fait par spin-coating (2000rpm pendant 30 secondes pour une épaisseur finale de 1,2µm) ou toute autre technique de dépôt de résine, suivi d'un recuit après dépôt de 115°C pendant 5 minutes sous N2.

### Troisième étape :

Comme représenté en figure 3c, on effectue une insolation face arrière de l'embase avec une machine d'insolation de type MA750. Le temps d'insolation peut varier de quelques dizaines de secondes à plusieurs minutes selon la transparence de la couche métallique 72. Pour une couche d'or d'environ 10nm, une insolation de 300 secondes avec une dose de 4,3mW/cm² est suffisante. Ceci permet d'insoler en une seule étape les deux couches de résines 71 et 73, et de rendre soluble dans un solvant approprié les parties de résine qui ont été exposées aux rayons lumineux.

### Quatrième étape :

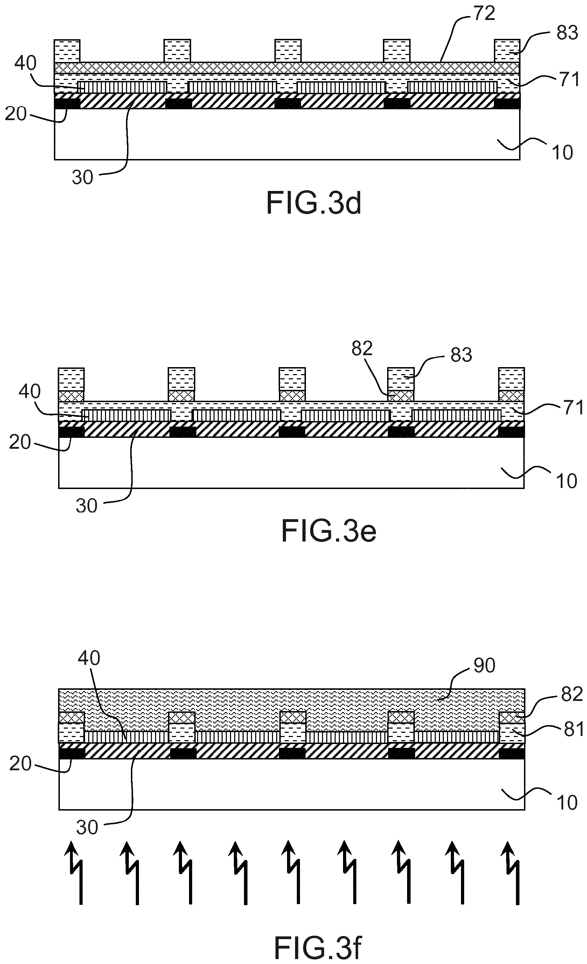

Comme représenté en figure 3d, on procède au développement de la couche de résine supérieure dans un développeur commercial à base de tétraméthyle Ammonium Hydroxide (environ 2% dans de l'eau) pendant 1 à 5mn. On réalise ainsi une partie préalable 83 en résine des plots du maillage, à la surface de la couche de métal 72.

### Cinquième étape :

Comme représenté en figure 3e, on procède à la gravure de la couche d'or par voie chimique avec une solution de KI/I₂ pendant 1 à 5 mn puis rinçage dans de l'eau déionisée et séchage sous N₂. On obtient ainsi les parties de métal 82 des plots, surmontés des parties 83 en résine des plots et permettant de définir le maillage en correspondance c'est-à-dire en regard des lignes/colonnes d'adressage 20.

### Sixième étape :

On procède au retrait des parties supérieures 83 en résine des plots, et de la résine 71 située au niveau (en regard) des électrodes inférieures 40 de manière à également dégager celles-ci, par gravure ionique réactive (RIE) dans un plasma d'oxygène (débit de 150sccm) avec 2% de SF6 à 10mTorr et une puissance de 120W pendant 10 minutes. On peut alors procéder au dépôt d'une couche de résine négative 90, telle que la résine SU8 de chez MicroChem, sur l'embase préconstituée par spin-coating, puis recuit à 115°C pendant 5 minutes. Cette résine négative 90 peut alors être insolée en face arrière comme représenté également en figure 3f.

### Septième étape :

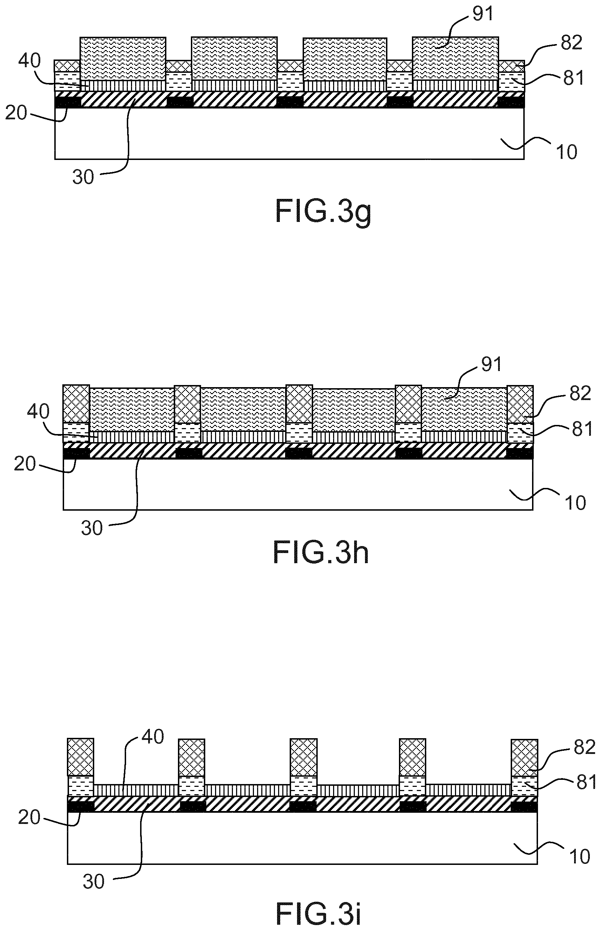

Comme représenté en figure 3g, le résultat de l'insolation de la résine photonégative est développé, permettant de dégager ladite résine négative en regard des plots 82/81.

### Huitième Etape :

Comme représenté en figure 3h, on procède à une opération de croissance de la couche de métal. Pour ce faire, le substrat est plongé dans une solution électrolyte afin de faire croitre la couche de métal seulement au-dessus des lignes/colonnes d'adressage. Différents complexes existent avec leurs avantages et leurs inconvénients, le plus répandu étant l'aurocyanure [Au(CN)₂]⁻. A ce complexe sont ajoutés des sels conducteurs (((NH4)2HPO4, K2HPO4, tartare de sodium et potassium ...), ainsi que des sels tampons pour stabiliser le pH. L'embase est reliée à la borne négative (Anode) d'un générateur continu de tension et la seconde borne (Cathode) est reliée à une électrode de platine (ou graphite). Avec un courant électrique de 20mA pendant 120 secondes et une surface de dépôt d'environ 0,8cm², l'épaisseur d'or déposée sur l'embase peut être d'environ 1µm, épaisseur largement suffisante pour avoir une excellente conductivité de l'électrode supérieure.

### Neuvième étape :

Comme représenté en figure 3i, on procède au retrait par voie chimique de l'ensemble des motifs en résine négatif qu'il reste sur la plaque en la plongeant dans de l'acétone pendant 5 à 10 minutes, suivi d'un rinçage à l'acétone et un séchage sous flux de N₂, laissant apparents les plots 82/81 du maillage métallique.

Une fois cette étape terminée, la réalisation de l'empilement photo-détecteur proprement dit peut être initié.

### Dixième étape :

Comme représenté en figure 3j, on procède au dépôt d'une couche photosensible 50 composée d'un mélange de polymères de type N et P. Elle peut être déposée par des techniques telles que le spin-coating, la sérigraphie. La proportion et la concentration des différents constituants, ainsi que l'épaisseur, le solvant ou la combinaison de solvants utilisés peuvent varier selon les techniques de dépôts utilisées, les performances finales visées, la solubilité des différents constituants ... Par exemple, le dépôt par spin-coating d'un mélange de 1 pour 2 dans du xylène (avec une concentration de 15mg/mL de polymère de type P) fournit une épaisseur d'environ 250nm sur un substrat de verre recouvert d'ITO, ceci pour une vitesse de spin de 800 rpm. Dans le cas représenté l'épaisseur de la couche 50 est supérieure à la hauteur des plots du maillage métallique.

### Onzième étape :

Comme représenté en figure 3k, on procède à une opération d'ablation laser de cette couche photosensible 50, seulement au niveau des lignes et colonnes d'adressage, afin de mettre à nu la couche de métal réalisée dans les étapes précédentes. L'ablation laser peut être réalisée par exemple avec un laser Excimer : pour une épaisseur de 270nm de couche active, il y a ablation pour deux pulses laser avec une fluence de 440mJ.

Il est à noter que selon l'épaisseur de la couche métallique et notamment si elle est trop fine, il est possible que celle-ci soit également gravée lors de l'ablation laser. Le contact électrique entre l'électrode supérieure et cette couche métallique n'est pas pour autant rompu mais a seulement lieu au niveau des flancs de la couche métallique.

### Douzième étape :

Comme représenté en figure 3I, on dépose l'électrode supérieure 60. Pour cela, de manière connue, le matériau déposé peut-être du PEDOT/PSS déposé en pleine couche, par des techniques de dépôt adaptées telles que la sérigraphie, le dépôt par centrifugation ou encore le dépôt par fente.

Cette électrode supérieure vient contacter le maillage métallique formé précédemment et ainsi diminuer de manière spectaculaire sa résistance carré.

### Second exemple de procédé de fabrication d'un dispositif matriciel de photodétection selon l'invention :

Il est possible de supprimer l'étape de croissance électrolytique, si la conductivité de la couche métallique est suffisante notamment dans le cas d'une couche épaisse de métal. Cette variante a pour principal avantage de diminuer le nombre d'étape de réalisation puisque l'utilisation d'une résine négative, d'une seconde étape de photolithographie et d'une étape d'électrodéposition ne sont pas nécessaires.

Ce procédé comprend des premières étapes similaires à celles du premier exemple de procédé et illustrée en figure 3a.

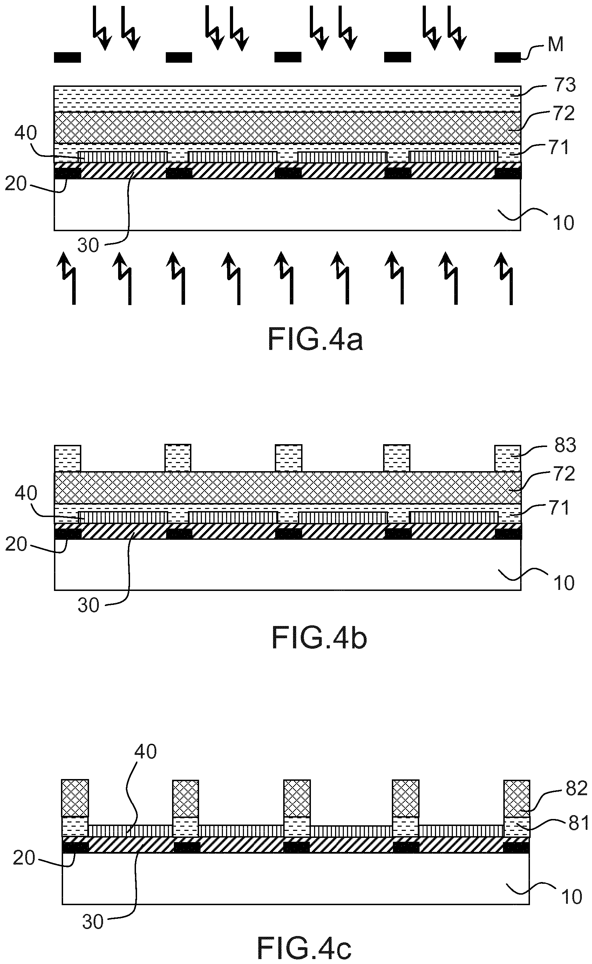

On procède dans le présent exemple au dépôt d'une couche épaisse de métal, permettant d'avoir une très bonne conductivité, comme illustré en figure 4a. On vient insoler en face avant à travers un masque M, et en face arrière (sans masque), l'embase préconstituée.

Comme dans le premier exemple de procédé, on révèle les parties supérieures 83 en résine, laissant à nu localement la couche épaisse de métal comme illustré en figure 4b.

On vient ensuite graver la couche épaisse de métal, puis graver la couche supérieure de résine, selon des méthodes identiques à celles précédemment décrites de manière à constituer les plots du maillage présentant une partie supérieure métallique 82 au dessus d'une partie de résine 81, comme représenté en figure 4c.

Les étapes ultérieures du procédé peuvent alors être identiques à celles du premier exemple de procédé de l'invention.

Selon une variante de l'invention, on peut également avantageusement procéder au démouillage de la couche photosensible 50 sur les plots de métal 82, conduisant à la suppression de l'étape d'ablation laser de la couche photosensible 50 au niveau des lignes et colonnes d'adressage. Pour cela, on peut immerger pendant 10 minutes l'embase dans une solution à 1% de 1H,1H,2H,2H-Perfluorodecanethiol dans de l'eau.

De manière générale, il apparait ainsi que le procédé de fabrication de la présente invention, permet de réaliser un maillage de lignes/colonnes qui a pour but de diminuer les capacités parasites entre l'électrode supérieure d'une matrice active de photo-détecteurs et les lignes/colonnes de commande des transistors de cette matrice. Il permet également, sans perte de surface active, de diminuer notablement la résistance carré de l'électrode supérieure en utilisant un maillage de lignes/colonnes métalliques connecté à l'électrode supérieure.

## Revendications

1. Dispositif matriciel de détection de rayonnement comportant un empilement comprenant une matrice de pixels d'éléments de détection, une matrice active comprenant un réseau de lignes et de colonnes de commande (20) desdits pixels réalisé à la surface d'un substrat (10),
- les pixels d'éléments de détection comprenant :
o une électrode supérieure commune (60) ;
o une couche de détection (50) ;
o des électrodes inférieures discrètes (40) ;
- ledit dispositif comprenant un maillage métallique relié à ladite électrode supérieure,
**caractérisé en ce que** :
o ledit maillage comporte des plots (80) présentant au moins une partie métallique, lesdits plots étant incorporés dans ladite couche de détection ;
o lesdits plots (80) du maillage métallique étant positionnés en regard du réseau de lignes et de colonnes de commande (20) et isolés de celui-ci, et séparant des éléments de la couche de détection (50), en étant en contact avec ladite couche (50) de détection.

2. Dispositif matriciel de détection de rayonnement selon la revendication 1, **caractérisé en ce que** la couche de détection (50) est une couche commune de détection.

3. Dispositif matriciel de détection de rayonnement selon l'une des revendications 1 ou 2, **caractérisé en ce que** les pixels de détection sont des photodiodes,

4. Dispositif matriciel de détection de rayonnement selon l'une des revendications 1 à 3, **caractérisé en ce que** le maillage métallique est séparé du réseau de lignes et de colonnes de commande, par une couche diélectrique (30) de permittivité inférieure à environ 2,5.

5. Dispositif matriciel de détection de rayonnement selon l'une des revendications 1 à 4, **caractérisé en ce que** lesdits plots comprennent une partie supérieure métallique (82) et une partie inférieure en matériau diélectrique (81).

6. Dispositif matriciel de détection de rayonnement selon la revendication 5, **caractérisé en ce que** la partie inférieure desdits plots (81) comporte une résine positive photosensible.

7. Dispositif matriciel de détection de rayonnement selon l'une des revendications 1 à 6, **caractérisé en ce que** les pixels d'éléments de détection comprennent un ou des matériau(x) organique(s).

8. Dispositif matriciel de détection de rayonnement selon la revendication 7, **caractérisé en ce que** le matériau organique est un mélange de polymère de type p et de polymère de type n.

9. Dispositif matriciel de détection de rayonnement selon l'une des revendications 1 à 8, **caractérisé en ce que** le réseau de lignes et de colonnes de commande desdits pixels est relié à un réseau de transistors de commande.

10. Procédé de fabrication d'un dispositif matriciel de détection de rayonnement selon la revendication 1, dont le réseau de lignes et de colonnes de commande (20) desdits pixels réalisé à la surface du substrat (10) et recouvert d'une couche de diélectrique (30), le procédé comportant les étapes suivantes :
- la réalisation des électrodes discrètes inférieures (40) ;
- le dépôt d'au moins une couche de détection (50) à la surface desdites électrodes inférieures ;
- la réalisation dudit maillage métallique comportant lesdits plots (80);
- la réalisation de ladite électrode commune supérieure (60) reliée auxdits plots du maillage métallique.

11. Procédé de fabrication d'un dispositif matriciel de détection de rayonnement selon la revendication 10, **caractérisé en ce qu'**il comprend les étapes suivantes :
- la réalisation d'un empilement de couches par les dépôts :
∘ d'une couche de résine photosensible positive dite inférieure (71) encapsulant lesdites électrodes discrètes inférieures de pixels élémentaires ;
∘ d'une couche de métal (72) ;
∘ d'une couche de résine photosensible positive dite supérieure (73) à la surface de ladite couche de métal ;
- l'insolation dudit empilement et le développement de ladite résine dite supérieure de manière à laisser des plots (83) constitués de ladite résine dite supérieure ;
- la gravure de ladite couche métallique de manière à former des plots comprenant une partie supérieure en résine (83) et une partie métallique (82) ;
- la gravure d'une couche supérieure formée de résine supérieure et de résine inférieure de manière à constituer des plots présentant une partie métallique (82) et une partie inférieure en résine (81) ;
- la réalisation de la couche de détection située au moins entre lesdits plots et laissant à nu la surface supérieure desdits plots ;
- le dépôt de la couche d'électrode supérieure au dessus de ladite couche de détection, en contact avec lesdits plots formés, permettant de constituer ledit maillage métallique.

12. Procédé de fabrication d'un dispositif, selon la revendication 11, **caractérisé en ce que** l'insolation de ladite résine positive est réalisée en face arrière dudit substrat, opposée à la surface comprenant ledit réseau de lignes et de colonnes de commande, ladite couche de métal étant d'épaisseur telle qu'elle laisse passer une partie du rayonnement d'insolation.

13. Procédé de fabrication d'un dispositif, selon la revendication 12, **caractérisé en ce que** l'insolation est effectuée également en face avant opposée à ladite face arrière, en présence d'un masque (M) présentant des ouvertures dites de masque, positionnées en regard desdites électrodes inférieures (40).

14. Procédé de fabrication d'un dispositif, selon l'une des revendications 11 ou 12, **caractérisé en ce qu'**il comprend en outre :
- le dépôt d'une résine négative postérieure à la réalisation desdits plots comprenant une partie supérieure métallique (82) ;
- l'insolation de ladite résine de manière à définir des ouvertures secondaires dans ladite résine négative, à la surface desdits plots de métal ;
- la croissance de métal dans lesdites ouvertures secondaires de manière à augmenter la hauteur desdits plots de métal.

15. Procédé de fabrication d'un dispositif, selon la revendication 14, **caractérisé en ce que** la croissance de métal est effectuée par voie électrolytique.

16. Procédé de fabrication d'un dispositif matriciel de détection de rayonnement selon l'une des revendications 10 à 15, **caractérisé en ce que** si la couche de détection recouvre lesdits plots, le procédé comprend en outre :
- la réalisation d'ouvertures dans ladite couche de détection en correspondance avec le réseau de lignes et de colonnes ;
- le dépôt de la couche d'électrode supérieure au dessus de ladite couche photosensible en contact avec lesdits plots formés (81, 82) et dans lesdites ouvertures permettant de constituer ledit maillage métallique.

17. Procédé de fabrication d'un dispositif matriciel de détection de rayonnement selon l'une des revendications 10 à 16, **caractérisé en ce qu'**il comprend une étape de démouillage de la couche de détection sur les plots présentant au moins une partie métallique permettant un contact direct de l'électrode supérieure avec lesdits plots.

## Patentansprüche

1. Matrixgerät zur Strahlungsdetektion, das einen Stapel mit einer Matrix von Detektionselementpixeln aufweist, wobei eine aktive Matrix ein Netzwerk von Steuerreihen und -spalten (20) der Pixel auf der Oberfläche eines Substrats (10) realisiert umfasst,
- wobei die Detektionselementpixel Folgendes umfassen:
o eine gemeinsame obere Elektrode (60);
o eine Detektionsschicht (50);
o diskrete untere Elektroden (40);
- wobei das Gerät ein mit der oberen Elektrode verbundenes Metallgitter umfasst,
**dadurch gekennzeichnet, dass**:
o das Gitter Pads (80) mit mindestens einem Metallabschnitt aufweist, wobei die Pads in die Detektionsschicht integriert sind;
o wobei die Pads (80) des Metallgitters gegenüber dem Netzwerk von Steuerreihen und -spalten (20) angeordnet und davon isoliert sind und die Elemente der Detektionsschicht (50) voneinander trennen, während sie mit der Detektionsschicht (50) in Kontakt stehen.

2. Matrixgerät zur Strahlungsdetektion nach Anspruch 1, **dadurch gekennzeichnet, dass** die Detektionsschicht (50) eine gemeinsame Detektionsschicht ist.

3. Matrixgerät zur Strahlungsdetektion nach einem der Ansprüche 1 oder 2, **dadurch gekennzeichnet, dass** die Detektionspixel Photodioden sind.

4. Matrixgerät zur Strahlungsdetektion nach einem der Ansprüche 1 bis 3, **dadurch gekennzeichnet, dass** das Metallgitter durch eine dielektrische Schicht (30) mit einer Dielektrizitätskonstante von weniger als etwa 2,5 von dem Netzwerk aus Steuerreihen und -spalten getrennt ist.

5. Matrixgerät zur Strahlungsdetektion nach einem der Ansprüche 1 bis 4, **dadurch gekennzeichnet, dass** die Pads einen metallischen oberen Abschnitt (82) und einen unteren Abschnitt (81) aus dielektrischem Material umfassen.

6. Matrixgerät zur Strahlungsdetektion nach Anspruch 5, **dadurch gekennzeichnet, dass** der untere Abschnitt der Pads (81) ein positives lichtempfindliches Harz aufweist.

7. Matrixgerät zur Strahlungsdetektion nach einem der Ansprüche 1 bis 6, **dadurch gekennzeichnet, dass** die Detektionselementpixel organische(s) Material(ien) umfassen.

8. Matrixgerät zur Strahlungsdetektion nach Anspruch 7, **dadurch gekennzeichnet, dass** das organische Material eine Mischung aus p-Typ-Polymer und n-Typ-Polymer ist.

9. Matrixgerät zur Strahlungsdetektion nach einem der Ansprüche 1 bis 8, **dadurch gekennzeichnet, dass** das Netzwerk von Steuerreihen und -spalten der Pixel mit einem Netzwerk von Steuertransistoren verbunden ist.

10. Verfahren zur Herstellung eines Matrixgeräts zur Strahlungsdetektion nach Anspruch 1, dessen Netzwerk von Steuerreihen und -spalten (20) der Pixel auf der Oberfläche des Substrats (10) realisiert und mit einer dielektrischen Schicht (30) bedeckt wird, wobei das Verfahren die folgenden Schritte aufweist:
- Realisieren der unteren diskreten Elektroden (40);
- Abscheiden mindestens einer Detektionsschicht (50) auf der Oberfläche der unteren Elektroden;
- Realisieren des Metallgitters, das die Pads (80) aufweist;
- Realisieren der oberen gemeinsamen Elektrode (60), die mit den Pads des Metallgitters verbunden ist.

11. Verfahren zur Herstellung eines Matrixgeräts zur Strahlungsdetektion nach Anspruch 10, **dadurch gekennzeichnet, dass** es die folgenden Schritte umfasst:
- Realisieren eines Stapels von Schichten durch Abscheiden:
o einer sogenannten unteren Schicht (71) aus lichtempfindlichem positivem Harz, die die unteren diskreten Elektroden von Elementarpixeln einkapselt;
o einer Metallschicht (72);
o einer sogenannten oberen Schicht (73) aus lichtempfindlichem positivem Harz auf der Oberfläche der Metallschicht;
- Belichten des Stapels und Entwickeln des sogenannten oberen Harzes, so dass Pads (83) aus dem sogenannten oberen Harz zurückbleiben;
- Ätzen der Metallschicht, um Pads, die einen oberen Abschnitt (83) aus Harz und einem Metallabschnitt (82) umfassen, zu bilden;
- Ätzen einer aus einem oberen Harz und einem unteren Harz gebildeten oberen Schicht, um Pads mit einem Metallabschnitt (82) und einem unteren Abschnitt (81) aus Harz zu bilden;
- Realisieren der Detektionsschicht, die sich mindestens zwischen den Pads befindet und die Oberseite der Pads freilässt;
- Abscheiden der oberen Elektrodenschicht auf der Detektionsschicht in Kontakt mit den gebildeten Pads, so dass das Metallgitter gebildet werden kann.

12. Verfahren zur Herstellung eines Geräts nach Anspruch 11, **dadurch gekennzeichnet, dass** die Belichtung des positiven Harzes auf der Rückseite des Substrats gegenüber der Oberfläche, die das Netzwerk von Steuerreihen und -spalten umfasst, erfolgt, wobei die Metallschicht eine solche Dicke aufweist, dass ein Teil der Belichtungsstrahlung durchgelassen wird.

13. Verfahren zur Herstellung eines Geräts nach Anspruch 12, **dadurch gekennzeichnet, dass** die Belichtung auch auf der der Rückseite gegenüberliegenden Vorderseite in Anwesenheit einer Maske (M) mit sogenannten Maskenöffnungen durchgeführt wird, die gegenüber den unteren Elektroden (40) positioniert ist.

14. Verfahren zur Herstellung eines Geräts nach einem der Ansprüche 11 oder 12, **dadurch gekennzeichnet, dass** es ferner Folgendes umfasst:
- Abscheiden eines negativen Harzes nach der Realisierung der Pads, die einen metallischen oberen Abschnitt (82) umfassen;
- Belichten des Harzes, um sekundäre Öffnungen in dem negativen Harz auf der Oberfläche der Metallpads zu definieren;
- Aufwachsenlassen von Metall in den sekundären Öffnungen, um die Höhe der Metallpads zu vergrößern.

15. Verfahren zur Herstellung eines Geräts nach Anspruch 14, **dadurch gekennzeichnet, dass** das Aufwachsenlassen von Metall elektrolytisch durchgeführt wird.

16. Verfahren zur Herstellung eines Matrixgeräts zur Strahlungsdetektion nach einem der Ansprüche 10 bis 15, **dadurch gekennzeichnet, dass**, wenn die Detektionsschicht die Pads bedeckt, das Verfahren ferner Folgendes umfasst:
- Realisieren von Öffnungen in der Detektionsschicht in Übereinstimmung mit dem Netzwerk von Reihen und Spalten;
- Abscheiden der oberen Elektrodenschicht auf der lichtempfindlichen Schicht in Kontakt mit den gebildeten Pads (81, 82) und in den Öffnungen, so dass das Metallgitter gebildet werden kann.

17. Verfahren zur Herstellung eines Matrixgeräts zur Strahlungsdetektion nach einem der Ansprüche 10 bis 16, **dadurch gekennzeichnet, dass** es einen Schritt des Entnetzens der Detektionsschicht auf den Pads mit mindestens einem Metallabschnitt umfasst, der einen direkten Kontakt der oberen Elektrode mit den Pads ermöglicht.

## Claims

1. A matrix-array detecting device having a stack comprising a matrix array of detecting-element pixels, and an active matrix array comprising a network (20) of rows and columns for controlling said pixels and produced on the surface of a substrate (10),
- the detecting-element pixels comprising:
o a common top electrode (60);
o a detecting layer (50);
o discrete bottom electrodes (40);
- said device comprising a metallic mesh that is connected to said top electrode,
**characterized in that**:
o said mesh having pads (80) with at least one metal portion, said pads being incorporated into said detecting layer;
o said pads (80) of the metallic mesh being positioned opposite of the network of controlling rows and columns (20) and isolated therefrom, and separating elements of the detecting layer (50) while being in contact with said detecting layer (50).

2. The matrix-array detecting device according to claim 1, **characterized in that** the detecting layer (50) is a common detecting layer.

3. The matrix-array detecting device according to one of claims 1 or 2, **characterized in that** the detecting pixels are photodiodes.

4. The matrix-array detecting device according to one of claims 1 to 3, **characterized in that** the metallic mesh is separated from the network of controlling rows and columns by a dielectric layer (30) of permittivity lower than about 2.5.

5. The matrix-array detecting device according to one of claims 1 to 4, **characterized in that** said pads comprise a metal top portion (82) and a bottom portion (81) made of dielectric material.

6. The matrix-array detecting device according to claim 5, **characterized in that** the bottom portion of said pads (81) has a positive photosensitive resin.

7. The matrix-array detecting device according to one of claims 1 to 6, **characterized in that** the detecting-element pixels comprise one or more organic materials.

8. The matrix-array detecting device according to claim 7, **characterized in that** the organic material is a blend of p-type polymer and n-type polymer.

9. The matrix-array detecting device according to one of claims 1 to 8, **characterized in that** the network of rows and columns for controlling said pixels is connected to a network of controlling transistors.

10. The process for fabricating a matrix-array detecting device according to claim 1, the network (20) of rows and columns for controlling said pixels of which is produced on the surface of the substrate (10) and covered with a dielectric layer (30), the process having the following steps:
- producing the discrete bottom electrodes (40);
- depositing at least one detecting layer (50) on the surface of said bottom electrodes;
- producing said metallic mesh including said pads (80):
- producing said common top electrode (60) connected to said pads of the metallic mesh.

11. The process for fabricating a matrix-array detecting device according to claim 10, **characterized in that** it comprises the following steps:
- producing a stack of layers by depositing:
o what is called a bottom layer (71) of positive photosensitive resin encapsulating said discrete bottom electrodes of the elementary pixels;
o a metal layer (72);
o what is called a top layer (73) of positive photosensitive resin on the surface of said metal layer;
- exposing said stack and developing said what is called top resin so as to leave behind pads (83) made of said what is called top resin;
- etching said metal layer so as to form pads comprising a top portion (83) made of resin and a metal portion (82);
- etching a top layer formed from top resin and from bottom resin so as to form pads having a metal portion (82) and a bottom portion (81) made of resin;
- producing the detecting layer located at least between said pads and leaving uncovered the top surface of said pads;
- depositing the top electrode layer on top of said detecting layer, in contact with said formed pads, allowing said metallic mesh to be produced.

12. The process for fabricating a device, according to claim 11, **characterized in that** said positive resin is exposed from the back side of said substrate, opposite the surface comprising said network of controlling rows and columns, said metal layer being of a thickness such that it lets some of the exposing radiation pass.

13. The process for fabricating a device, according to claim 12, **characterized in that** the exposure is also carried out from the front side opposite said back side, in the presence of a mask (M) having what are called mask apertures, positioned facing said bottom electrodes (40).

14. The process for fabricating a device, according to one of claims 11 or 12, **characterized in that** it further comprises:
- depositing a negative resin after said pads comprising a metal top portion (82) have been produced;
- exposing said resin so as to define secondary apertures in said negative resin, on the surface of said metal pads;
- growing metal in said secondary apertures so as to increase the height of said metal pads.

15. The process for fabricating a device, according to claim 14, **characterized in that** the metal is grown electrolytically.

16. The process for fabricating a matrix-array detecting device according to one of claims 10 to 15, **characterized in that** if the detecting layer covers said pads, the process further comprises:
- producing apertures in said detecting layer in correspondence with the network of rows and columns;
- depositing the top electrode layer on said photosensitive layer in contact with said formed pads (81, 82) and in said apertures, allowing said metallic mesh to be produced.

17. The process for fabricating a matrix-array detecting device according to one of claims 10 to 16, **characterized in that** it comprises a step of de-wetting the detecting layer on the pads having at least one metal portion allowing a direct contact of the top electrode with said pads.
